# EUROPÄISCHE PATENTSCHRIFT

(11) **EP 1 771 052 B1**
(45) Veröffentlichungstag und Bekanntmachung des Hinweises auf die Patenterteilung: **18.11.2015**
(21) Anmeldenummer: 06020226.4
(22) Anmeldetag: 27.09.2006
(51) Int. Cl.: E05B 81/24, E05B 85/02, E05B 81/54, H05K 5/00

(54) **Komponententräger zur Aufnahme von elektrischen/elektronischen Bauelementen in insbesondere Kraftfahrzeugtürschlössern**
Support for electric/electronic components, especially for in a vehicle door lock.
Support pour composants électriques/électroniques en particulier dans une serrure de portière de véhicule automobile

(30) Priorität: 30.09.2005 DE 202005015588 U
(43) Veröffentlichungstag der Anmeldung: 04.04.2007
(73) Patentinhaber: Kiekert Aktiengesellschaft, 42579 Heiligenhaus (DE)
(72) Erfinder: Seubold, Karin, 47239 Duisburg (DE); Beck, Andreas, 44795 Bochum (DE)

(56) Entgegenhaltungen:
- EP-A1- 0 426 535
- EP-A1- 0 894 920
- EP-A1- 0 959 205
- DE-U1- 20 307 111
- US-A- 6 028 770
- US-A1- 2001 043 465

## Beschreibung

Die Erfindung betrifft ein System von Komponententrägern zur Aufnahme von elektrischen/elektronischen Bauelementen in insbesondere Kraftfahrzeugtürschlössern, mit zumindest einem elektrischen Anschlusselement, ferner mit einem Trägerelement, und mit einem Leiterbahngebilde zur elektrischen Kontaktierung der Bauelemente. - In der Regel und nicht einschränkend ist das Leiterbahngebilde flächig ausgeführt.

Bei einem Komponententräger der eingangs beschriebenen Ausgestaltung entsprechend der DE 203 07 111 U1 ist der Komponententräger als Bestandteil des Schlossgehäuses bei einem Kraftfahrzeugtürschloss ausgeführt. In diesem Zusammenhang bilden das Anschlusselement und das Leiterbahngebilde eine vorgefertigte Baueinheit, die im Ganzen in den Komponententräger bzw. das Schlossgehäuse eingesetzt werden kann. Auf diese Weise wird die Herstellung einer Vergusseinheit insgesamt vereinfacht. Das hat sich bewährt.

Der Komponententräger bzw. das Trägerelement nimmt beispielhaft und nicht einschränkend im Kraftfahrzeugtürschloss befindliche Elektrokomponenten, wie z. B. Motoren, Mikroschalter etc. auf. Mit Hilfe des Leiterbahngebildes werden diese Elektrokomponenten bzw. elektrischen/elektronischen Bauelemente einerseits mit Strom versorgt und andererseits beispielsweise mit einer Steueranlage im Innern des Kraftfahrzeuges verbunden. Dadurch können sensorische Aufgaben übernommen werden, wie beispielsweise das Abfragen der Stellung der Drehfalle mit einem Mikroschalter etc..

Um nun die hierzu erforderlichen externen elektrischen Verbindungsleitungen bzw. Anschlussleitungen mit dem Leiterbahngebilde elektrisch zu kontaktieren, ist das Anschlusselement zumeist als Buchse ausgeführt, in die ein zugehöriger Stecker endseitig der Verbindungsleitungen eingesteckt wird. Selbstverständlich kann auch umgekehrt mit einem Stecker als Anschlusselement gearbeitet werden, auf den eine Buchse endseitig der Verbindungsleitungen aufgesteckt wird. Hierbei werden in der Praxis im Allgemeinen zwei grundsätzliche Anschlussarten unterschieden.

Zum einen kann das Anschlusselement im so genannten Feuchtraum platziert werden, also beispielsweise jenseits einer Spritzschutzfolie oder dergleichen im Innern einer zugehörigen Kraftfahrzeugtür, das heißt vor Umwelteinflüssen und insbesondere Feuchtigkeit weitgehend geschützt. Andere Anwendungen sehen jedoch ein Anschlusselement vor, welches im Nassraum außerhalb der Schutzfolie angeordnet ist und den Witterungseinflüssen damit stärker ausgesetzt.

Bisher erfordern beide Lösungen unterschiedlich gestaltete Trägerelemente, Anschlusselemente und zugehörige Leiterbahngebilde. Darüber hinaus müssen oft auch weitere Bestandteile des Türschlosses wie Gehäuse und Gehäusedeckel angepasst werden. Das ist aufwendig. Hier setzt die Erfindung ein.

Der Erfindung liegt das technische Problem zugrunde, ein derartiges System von Komponententrägen so zu entwickeln, dass auf möglichst viele gleich aufgebaute Bauteile auch bei unterschiedlichen Anforderungen zurückgegriffen werden kann und eine gleichsam standardisierte Herstellung gelingt.

Zur Lösung dieser technischen Problemstellung ist ein gattungsgemäßes System von Komponententrägern im Rahmen einer ersten Alternative dadurch gekennzeichnet, dass zwei oder mehr Anschlusselemente am Trägerelement vorgesehen sind, die wahlweise oder gemeinsam aktiviert werden, indem ein zu dem Aktivierungswunsch korrespondierendes und einbaufertiges Leiterbahngebilde ausgewählt und eingesetzt

Erfindungsgemäß verfügt der Komponententräger also über wenigstens zwei Anschlusselemente, die so ausgestaltet sein mögen, dass einerseits ein Anschluss im Feuchtraum und andererseits ein Anschluss im Nassraum ermöglicht wird. Die Aktivierung des jeweils gewünschten Anschlusselementes Anschluss im Feuchtraum und andererseits ein Anschluss im Nassraum ermöglicht wird. Die Aktivierung des jeweils gewünschten Anschlusselementes erfolgt nun durch die passende Auswahl des den Aktivierungswunsch widerspiegelnden Leiterbahngebildes. Wird beispielsweise eine Anbindung im Nassraum gewünscht, so kommt das Leiterbahngebilde für den Nassraum zum Einsatz und kontaktiert das Anschlusselement für den Nassraum. Ist dagegen eine Kontaktierung im Feuchtraum vorgesehen, so wird das Leiterbahngebilde für den Feuchtraum ausgewählt, und sorgt dafür, dass das andere der beiden Anschlusselemente, nämlich das für den Feuchtraum, aktiviert wird.

Dabei wird im Einzelnen die Aktivierung so vorgenommen, dass das Leiterbahngebilde mit wenigstens einem Kontaktelement in das jeweils zu aktivierende Anschlusselement zu seiner Kontaktierung eintaucht. Anders ausgedrückt, zeichnet sich das jeweils aktivierte Anschlusselement dadurch aus, dass in seinem Innern das wenigstens eine Kontaktelement an einem Boden des Anschlusselementes angeordnet ist, so dass der zuvor bereits beschriebene und mit dem Anschlusselement verbundene Stecker am Ende der Verbindungsleitungen mit dem oder den Kontaktelementen eine elektrische Verbindung eingehen kann. Meistens kragt das Kontaktelement von dem besagten Boden des Anschlusselementes vor. Es kann aber auch beispielsweise in einer Vertiefung des Bodens so angeordnet sein, dass der mit dem Anschlusselement verbundene Stecker in die Vertiefung mit einem Kontaktstift eindringt und so die erforderliche elektrische Verbindung herstellen. Ist dagegen das Anschlusselement deaktiviert, so findet sich kein an oder in dem Boden des Anschlusselementes angeordnetes Kontaktelement, so dass ein eingesteckter Stecker mit dem Leiterbahngebilde naturgemäß keine Verbindung eingehen kann.

Jedenfalls wird der jeweilige Aktivierungswunsch dadurch berücksichtigt, dass das zu dem Aktivierungswunsch korrespondierende einbaufertige Leiterbahngebilde ausgewählt wird. Dabei erfolgt die Auswahl des Leiterbahngebildes bevor das Trägerelement und die Anschlusselemente hergestellt werden. Denn üblicherweise ist das Leiterbahngebilde in das Trägerelement eingebettet und wird zusammen mit diesem gefertigt. Je nach dem ausgewählten Leiterbahngebilde verfügt der auf diese Weise hergestellte Komponententräger unmittelbar über das wunschgemäß aktivierte Anschlusselement, im Beispielfall dasjenige für die Verbindung im Feuchtraum oder dasjenige im Nassraum.

Selbstverständlich können auch beide oder noch mehr Anschlusselemente insgesamt aktiviert werden. In diesem Fall wird man - um Kriechströme oder Kurzschlüsse zu vermeiden - jedoch das nicht benötigte Anschlusselement mit einem Verschlussdeckel abdecken.

Sämtliche zuvor beschriebenen Vorteile und Wirkungen kommen auch dann zum Tragen, wenn der Komponententräger nach einer alternativen Ausgestaltung arbeitet. In diesem Fall ist bei einem gattungsgemäßen Komponententräger vorgesehen, dass zwei oder mehr Anschlusselemente realisiert sind, die wahlweise oder gemeinsam aktiviert werden, indem ein Basis-Leiterbahngebilde dem Aktivierungswunsch entsprechend zu dem einbaufertigen Leiterbahngebilde modifiziert wird. Das heißt, die Erfindung greift in diesem Fall auf ein gleich aufgebautes Basis-Leiterbahngebilde zurück - egal ob nun im Beispielfall das Anschlusselement für den Feuchtraum oder dasjenige für den Nassraum oder beide Anschlusselemente durch den anschließenden Herstellungsvorgang aktiviert werden sollen oder nicht. Dieses Basis-Leiterbahngebilde wird dem Aktivierungswunsch entsprechend modifiziert und definiert am Ende dieses Vorganges das einbaufertige Leiterbahngebilde, welches seinerseits - wie bereits beschrieben - in das Trägerelement eingebettet und einstückig mit dem Trägerelement und den Anschlusselementen hergestellt wird.

Das geschieht in sämtlichen Fällen üblicherweise durch Spritzgießen, indem das einbaufertige Leiterbahngebilde in eine Spritzgussform eingelegt sowie hierin platziert wird und im Anschluss daran das Trägerelement die einstückig mit dem Trägerelement ausgeführten Anschlusselemente ein- bzw. umspritzt werden. Zu diesem Zweck greift die Erfindung in der Regel auf einen thermoplastischen Kunststoff für diesen Kunststoffspritzgussvorgang zurück.

Das Basis-Leiterbahngebilde lässt sich vorteilhaft zu dem einbaufertigen Leiterbahngebilde modifizieren, indem einzelne oder alle Leiterbahnen abgekantet und/oder gekürzt (oder gegebenenfalls auch verlängert) werden. Je nach dem Aktivierungswunsch werden ein oder mehrere Modifizierungsschritte für das Basis-Leiterbahngebilde dem beschriebenen Herstellungsvorgang für den Komponententräger vorgeschaltet. Jedenfalls steht am Ende das einbaufertige Leiterbahngebilde zur Verfügung und wird im Zuge des beschriebenen Kunststoffspritzgussvorganges zu dem Komponententräger mit Trägerelement und Anschlusselementen vervollständigt.

Weiter hat es sich bewährt, wenn das Trägerelement zwischen Bestandteilen des Kraftfahrzeugtürschlosses, beispielsweise Deckel und Gehäuse, aufgenommen wird. Auf diese Weise kann das Kraftfahrzeugtürschloss modular hergestellt werden, indem Schlosskasten, Gehäuse ggf. Deckel und Komponententräger bzw. Trägerelement mit den darauf befindlichen elektrischen/ elektronischen Bauelementen vereinigt werden. In diesem Zusammenhang nehmen die beiden Anschlusselemente gegenüber dem Kraftfahrzeugtürschloss eine exponierte Position ein, damit nach dem Zusammenbau der Stecker mit den Verbindungsleitungen problemlos in das zugehörige Anschlusselement eingesteckt werden kann.

In der Regel handelt es sich bei dem flächigen (einbaufertigen) Leiterbahngebilde um ein so genanntes Stanzgitter, welches durch einen Metallstanzvorgang aus einer Metallplatte bzw. Metallfolie oder auch einer metallbeschichteten Kunststofffolie hergestellt werden kann. Grundsätzlich sind aber auch andere flächige Leiterbahngebilde wie biegsame Leiterbahnfolien etc. denkbar und werden vom Erfindungsgedanken umfasst.

Zusätzliche Dichtungen zwischen dem Trägerelement und den Bestandteilen des Kraftfahrzeugtürverschlusses, insbesondere Schlosskasten und Gehäuse, sorgen dafür, dass der Komponententräger zusammen mit den vorerwähnten Bestandteilen eine insgesamt abgedichtete Baueinheit formt. Ferner mögen Dichtungen im Bereich der Anschlusselemente vorgesehen sein, die verhindern, dass bei eingestecktem Stecker Feuchtigkeit ins Innere des Kraftfahrzeugtürschlosses gelangt. Selbstverständlich können diese Dichtungen im Bereich der Anschlusselemente je nach deren Aktivierung wahlweise vorgesehen werden oder nicht. Denn ein nicht aktiviertes Anschlusselement braucht naturgemäß nicht zusätzlich abgedichtet zu werden.

Im Ergebnis wird ein Komponententräger vorgestellt, welcher eine universelle Lösung zur Verbindung von elektrischen/elektronischen Bauelementen im Innern von insbesondere Kraftfahrzeugtürschlössern mit der Peripherie zur Verfügung stellt, und zwar wahlweise im Feuchtraum oder Nassraum. Dadurch können individuelle Kundenwünsche zur Anbindung berücksichtigt werden. Der standardisierte Aufbau und Rückgriff auf möglichst viele übereinstimmende Komponenten reduziert insgesamt die anfallenden Kosten. Hierin sind die wesentlichen Vorteile zu sehen.

Im Folgenden wird die Erfindung anhand einer lediglich ein Ausführungsbeispiel darstellenden Zeichnung näher erläutert; es zeigen:
- **Fig. 1 und 2**: zwei verschiedene Versionen des erfindungsgemäßen Komponententrägers, einerseits zur Anbindung im Nassraum (Fig. 1) und andererseits im Feuchtraum (Fig. 2) und

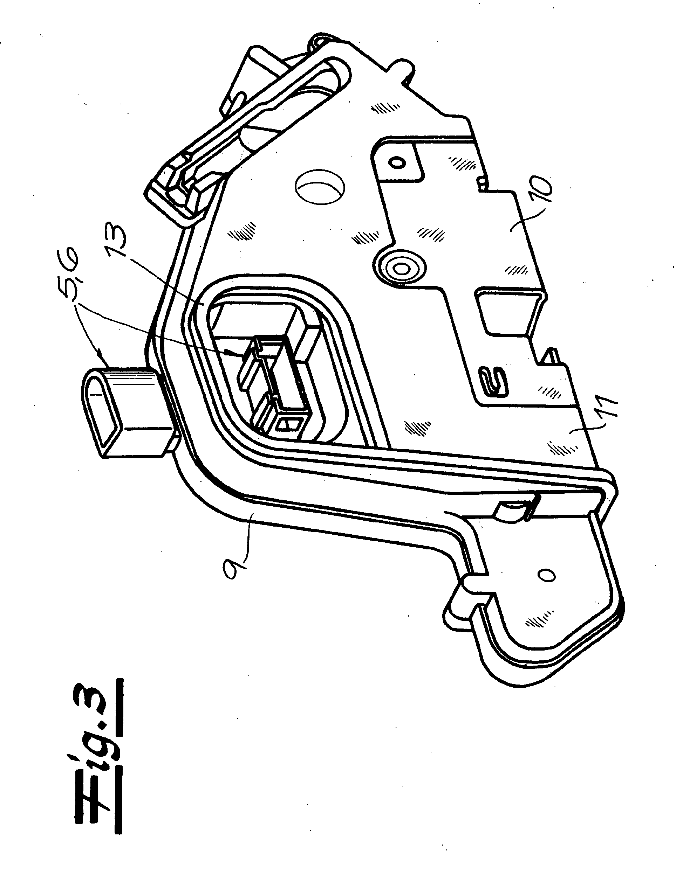

- **Fig. 3**: das zugehörige Kraftfahrzeugtürschloss mit dem Komponententräger in einer perspektivischen Ansicht.

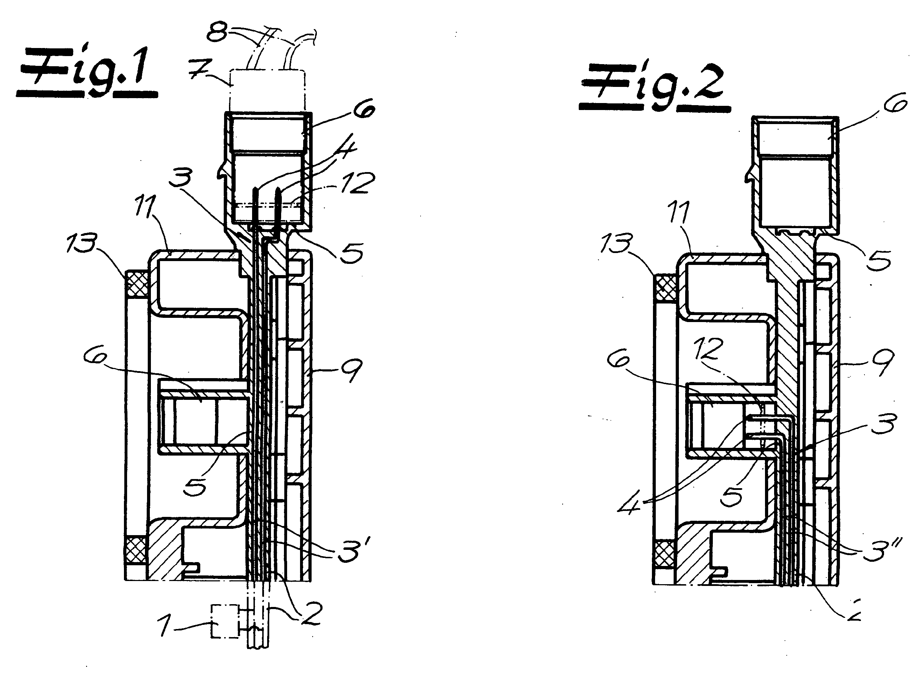

In den Figuren ist ein Komponententräger dargestellt, welcher zur Aufnahme einzelner und lediglich in Fig. 1 angedeuteter elektrischer/elektronischer Bauelemente 1 geeignet ist. Tatsächlich werden die betreffenden Bauelemente 1 von einem Trägerelement 2 gehalten und mit Hilfe eines flächigen sowie einbaufertigen Leiterbahngebildes 3 kontaktiert. Das flächige Leiterbahngebilde 3 mündet in Kontaktelemente 4, die von einem Boden 5 eines Anschlusselementes 5, 6 mit Buchsenöffnung vorkragen. Dadurch kann ein in das Anschlusselement 5, 6 eingesteckter Stecker 7 im Beispielfall eine elektrische Verbindung zu Anschlussleitungen 8 herstellen, die wiederum mit einer nicht dargestellten Steuereinrichtung bzw. Steueranlage und/oder einer Energiequelle in Verbindung stehen.

Auf diese Weise ist die angesprochene Steueranlage im Beispielfall in der Lage, mit Hilfe des als Schalter ausgeführten Bauelementes 1 unter anderem die Stellung einer nicht dargestellten Drehfalle im Innern des jeweils gezeigten Kraftfahrzeugtürschlosses abfragen zu können. Auch die Versorgung von Motoren im Kraftfahrzeugtürschloss wird mit Hilfe der Anschlussleitungen 8 sichergestellt, die für den Stromtransport über das Leiterbahngebilde 3 hin zum jeweiligen Motor sorgen.

Man erkennt, dass das jeweils dargestellte Kraftfahrzeugtürschloss aus im Wesentlichen vier Bestandteilen aufgebaut ist, nämlich einem Schlossgehäuse 9 bzw. Gehäuse 9, einem Schlosskasten 10 und einem Schlossdeckel 11 sowie dem Komponententräger 2, 3, 4, 5, 6, welcher sich aus dem Trägerelement 2, dem in das Trägerelement 2 eingebetteten Leiterbahngebilde 3 und den an das Trägerelement 2 angeschlossenen Anschlusselementen 5, 6 zusammensetzt. Tatsächlich sind zwei Anschlusselemente 5, 6 vorgesehen, die in LängserStreckung und quer zur Längserstreckung des Trägerelementes 2 angeordnet sind.

Die beiden Anschlusselemente 5, 6 können wahlweise oder gemeinsam aktiviert werden. Das bedeutet im Rahmen der Erfindung, dass das jeweils aktivierte Anschlusselement 5, 6 mit dem Kontaktelement 4 des Leiterbahngebildes 3 ausgerüstet ist, welches über den Boden 5 des Anschlusselementes 5, 6 vorkragt und in das Anschlusselement 5, 6 zu dessen Kontaktierung eintaucht. Man erkennt, dass in der Fig. 1 das obere Anschlusselement 5, 6 zur Verbindung mit dem Stecker 7 im Nassraum aktiviert ist, während bei der Variante nach Fig. 2 das Anschlusselement 5, 6 im Feuchtraum eine Aktivierung aufweist.

Erfindungsgemäß bestehen zwei Möglichkeiten, das jeweilige Anschlusselement 5, 6 zu aktivieren. Zunächst einmal kann ein zu dem Aktivierungswunsch korrespondierendes Leiterbahngebilde 3 ausgewählt werden. Das heißt, die Erfindung unterscheidet beispielhaft zwischen einem Leiterbahngebilde 3' für die Nassraumkontaktierung entsprechend der Fig. 1 und einem solchen für die Feuchtraumkontaktierung 3" nach der Fig. 2. Im erstgenannten Fall finden sich die besagten Kontaktelemente 4 lediglich in dem Anschlusselement 5, 6 im Nassraum, während die letztgenannte Variante zu Kontaktelementen 4 im Anschlusselement 5, 6 des Feuchtraumes korrespondiert. Beide verschieden gestalteten Leiterbahngebilde 3', 3" sind jeweils einbaufertig.

In jedem Fall sind sämtliche übrigen Bauteile deckungsgleich und wird der Aktivierungswunsch nur durch das jeweils unterschiedlich gestaltete Leiterbahngebilde 3 bzw. 3', 3" abgebildet. Tatsächlich wird das ausgewählte und einbaufertige Leiterbahngebilde 3 bzw. 3', 3" zu diesem Zweck in eine Kunststoffspritzgussform eingelegt und hierin positioniert, wobei sich im Anschluss ein Kunststoffspritzgussvorgang anschließt, welcher das Leiterbahngebilde 3 bzw. 3', 3" mit dem Trägerelement 2 umhüllt und die beiden Anschlusselemente 5, 6 ausformt. Dabei sind die Spritzgussform, der Schlosskasten 10, das Gehäuse 9 und der Gehäusedeckel 11 sowie sämtliche weiteren Bauteile im Inneren des Schlosskastens völlig identisch, ob nun mit dem Nassraumanschluss entsprechend der Fig. 1 oder dem Feuchtraumanschluss nach Fig. 2 gearbeitet wird.

Das Gleiche gilt für die alternative Vorgehensweise, bei welcher die Aktivierung des ausgewählten Anschlusselementes 5, 6 dadurch vorgenommen wird, dass ein nicht ausdrücklich dargestelltes Basis-Leiterbahngebilde dem Aktivierungswunsch entsprechend zu dem einbaufertigen Leiterbahngebilde 3 modifiziert wird. Diese Modifikation kann so aussehen, dass das Basis-Leiterbahngebilde 3 durch Abkanten und/oder Kürzen einzelner oder aller Leiterbahnen in das einbaufertige Leiterbahngebilde 3 umgewandelt wird.

In beiden Fällen ist anschließend das Trägerelement 2 bzw. der Komponententräger 2, 3, 4, 5, 6 insgesamt zwischen dem Schlosskasten 10 und dem Gehäuse 9 platziert, und zwar dichtend. Die beiden Anschlusselemente 5, 6 kragen gegenüber dem Kraftfahrzeugtürschloss vor und nehmen die dargestellte exponierte Position ein, damit der Stecker 7 einwandfrei in das gewünschte Anschlusselement 5, 6 eingesteckt werden kann.

Bei dem Leiterbahngebilde 3 handelt es sich um ein Stanzgitter, welches durch einen Metallstanzvorgang aus einer Metallplatte hergestellt werden kann. Zusätzliche und lediglich angedeutete Dichtungen 12, 13 sorgen dafür, dass das Trägerelement 2 respektive der Schlosskasten 10 und das Gehäuse 9 und/ oder der Bereich der Anschlusselemente 5, 6 abgedichtet werden.

## Patentansprüche

1. System von Komponententrägern zur Aufnahme von elektrischen/ elektronischen Bauelementen (1) in insbesondere Kraftfahrzeugtürschlössern mit wenigstens einem gemeinsamenTrägerelement (2) mit zumindest einem elektrischen Anschlusselement (5, 6), und mit einem Leiterbahngebilde (3) zur elektrischen Kontaktierung der Bauelemente (1), **dadurch gekennzeichnet, dass** zwei oder mehr Anschlusselemente (5, 6) am Trägerelement vorgesehen sind, die wahlweise oder gemeinsam aktiviert werden, indem ein zu dem Aktivierungswunsch korrespondierendes einbaufertiges Leiterbahngebilde (3; 3', 3") ausgewählt und eingesetzt wird.

2. System von Komponententrägern zur Aufnahme von elektrischen/ elektronischen Bauelementen (1) in insbesondere Kraftfahrzeugtürschlössern, mit wenigstens einem gemeinsamenTrägerelement (2) mit zumindest einem elektrischen Anschlusselement (5, 6), und mit einem flächigen Leiterbahngebilde (3) zur elektrischen Kontaktierung der Bauelemente (1), **dadurch gekennzeichnet, dass** zwei oder mehr Anschlusselemente (5, 6) am Trägerelement vorgesehen sind, die wahlweise oder gemeinsam aktiviert werden, indem ein dem Aktivierungswunsch entsprechendes modifiziertes Basis-Leiterbahngebilde als einbaufertiges Leiterbahngebilde (3) eingesetzt wird.

3. System von Komponententrägern nach einem der Ansprüche 1 bis 2, **dadurch gekennzeichnet, dass** die beiden Anschlusselemente (5, 6) in Längserstreckung und quer zur Längserstreckung des Trägerelementes (2) angeordnet sind.

4. System von Komponententrägern nach einem der Ansprüche 1 bis 3, **dadurch gekennzeichnet, dass** die beiden Anschlusselemente (5, 6) einstückig mit dem Trägerelement (2) ausgebildet sind.

5. System von Komponententrägern nach einem der Ansprüche 1 bis 4, **dadurch gekennzeichnet, dass** das Leiterbahngebilde (3) in das Trägerelement (2) eingebettet ist und zusammen mit diesem gefertigt wird.

6. System von Komponententrägern nach einem der Ansprüche 1 bis 5, **dadurch gekennzeichnet, dass** das Leiterbahngebilde (3) mit wenigstens einem Kontaktelement (4) in das Anschlusselement (5, 6) zu dessen Kontaktierung eintaucht.

7. System von Komponententrägern nach einem der Ansprüche 1 bis 6, **dadurch gekennzeichnet, dass** das Trägerelement (2) zwischen Bestandteilen des Kraftfahrzeugtürschlosses, beispielsweise Deckel (11) und Gehäuse (9), aufgenommen wird.

8. System von Komponententrägern nach einem der Ansprüche 1 bis 7, **dadurch gekennzeichnet, dass** das Leiterbahngebilde (3) vorzugsweise flächig und als Stanzgitter ausgeführt ist.

9. System von Komponententrägern nach einem der Ansprüche 1 bis 8, **dadurch gekennzeichnet, dass** Dichtungen (12, 13) zwischen dem Trägerelement (2) und den Bestandteilen (9, 10) des Kraftfahrzeugtürschlosses und/oder im Bereich der Anschlusselemente (5, 6) vorgesehen sind.

10. Verfahren zur Herstellung eines Komponententrägers von einem System von Komponententrägern nach einem der Ansprüche 1-9, zur Aufnahme von elektrischen/elektronischen Bauelementen (1) in insbesondere Kraftfahrzeugtürschlössern, mit wenigstens einem gemeinsamenTrägerelement (2), ferner mit zumindest einem elektrischen Anschlusselement (5, 6), und mit einem Leiterbahngebilde (3) zur elektrischen Kontaktierung der Bauelemente (1), **dadurch gekennzeichnet, dass** zwei oder mehr Anschlusselemente (5, 6) vorgesehen sind, die wahlweise oder gemeinsam aktiviert werden, indem ein zu dem Aktivierungswunsch korrespondierendes einbaufertiges Leiterbahngebilde (3; 3', 3") ausgewählt und eingesetzt wird.

11. Verfahren zur Herstellung eines Komponententrägers von einem System von Komponententrägern nach einem der Ansprüche 1-9 zur Aufnahme von elektrischen/elektronischen Bauelementen (1) in insbesondere Kraftfahrzeugtürschlössern, mit wenigstens einem gemeinsamenTrägerelement (2), ferner mit zumindest einem elektrischen Anschlusselement (5, 6), und mit einem Leiterbahngebilde (3) zur elektrischen Kontaktierung der Bauelemente (1), **dadurch gekennzeichnet, dass** zwei oder mehr Anschlusselemente (5, 6) vorgesehen sind, die wahlweise oder gemeinsam aktiviert werden, indem ein Basis-Leiterbahngebilde dem Aktivierungswunsch entsprechend zu dem einbaufertigen Leiterbahngebilde (3) modifiziert und eingesetzt wird.

12. Verfahren zur Herstellung eines Komponententrägers von einem System von Komponententrägern nach einem der Ansprüche 1-9 und Anspruch 11, **dadurch gekennzeichnet, dass** das Basis-Leiterbahngebilde durch Abkanten und/oder Kürzen einzelner oder aller Leiterbahnen in das einbaufertige Leiterbahngebilde (3) umgewandelt wird.

13. Verfahren zur Herstellung eines Komponententrägers von einem System von Komponententrägern nach einem der Ansprüche 1-12, **dadurch gekennzeichnet, dass** das Leiterbahngebilde (3) in das Trägerelement (2) eingebettet ist und zusammen mit diesem gefertigt wird.

14. Verfahren zur Herstellung eines Komponententrägers von einem System von Komponententrägern nach einem der Ansprüche 1-13, **dadurch gekennzeichnet, dass** die beiden Anschlüsse (5, 6) einstückig mit dem Trägerelement (2) hergestellt werden.

## Claims

1. System of component carriers on which electric/electronic components (1) are mounted, in particular, motor vehicle door latches with at least one common carrier element (2), containing at least one electric connecting element (5,6) and a strip conductor arrangement (3) providing the electric contact for the components (1), **characterized in that** two or more connecting elements (5, 6) are provided on the carrier element that can be selectively or jointly activated by a strip conductor arrangement (3; 3', 3"), corresponding to the activation request, being selected and used.

2. System of component carriers on which electric/electronic components (1) are mounted, in particular, motor vehicle door latches with at least one common carrier element (2), containing at least one electric connecting element (5, 6) and a planar strip conductor arrangement (3) for electric contacting of the components (1), **characterized in that** two or more connecting elements (5, 6) are provided on the carrier element that can be selectively or jointly activated by using a modified basic conductor track element, corresponding to the activation request, as a ready-to-install strip conductor arrangement.

3. System of component carriers according to one of the claims 1 to 2 **characterized in that** the two connecting elements (5, 6) are arranged in longitudinal direction and transversely to the longitudinal direction of the carrier element (2).

4. System of component carriers according to one of the claims 1 to 3 **characterized in that** the two connecting elements (5, 6) form a single part together with the carrier element (2).

5. System of component carriers according to one of the claims 1 to 4 **characterized in that** the conductor track element (3) is embedded in the carrier element (2) and is produced together with said carrier element.

6. System of component carriers according to one of the claims 1 to 5 **characterized in that** at least one contact element (4) of the strip conductor arrangement (3) is immersed in the connecting element (5, 6) for contacting.

7. System of component carriers according to one of the claims 1 to 6, **characterized in that** the carrier element (2) is accommodated between components of the motor vehicle door latch, for instance the cover (11) and housing (9).

8. System of component carriers according to one of the claims 1 to 7 **characterized in that** the strip conductor arrangement (3) is preferably planar and is a lead frame.

9. System of component carriers according to one of the claims 1 to 8 **characterized in that** the seals (12, 13) are provided between the carrier element (2) and the components (9, 10) of the motor vehicle door latch and/or in the area of the connecting elements (5, 6).

10. Method for producing a component carrier of a system of component carriers according to one of the claims 1-9 for accommodating electric/electronic components (1), in particular, motor vehicle door latches with at least one common carrier element (2), containing also at least one electric connecting element (5,6) and a strip conductor arrangement (3) providing the electric contact for the components (1), **characterized in that** the two or more connecting elements (5, 6) are provided that can be selectively or jointly activated by a strip conductor arrangement (3; 3', 3"), corresponding to the activation request, being selected and used.

11. Method for producing a component carrier of a system of component carriers according to one of the claims 1-9 for accommodating electric/electronic components (1), in particular, motor vehicle door latches with at least one common carrier element (2), containing also at least one electric connecting element (5, 6) and a strip conductor arrangement (3) providing the electric contact for the components (1), **characterized in that** the two or more connecting elements (5, 6) are provided that are selectively or jointly activated by a basic strip conductor arrangement being used that is modified in accordance with the activation request to form the ready-to-install strip conductor arrangement (3).

12. Method for producing a component carrier of a system of component carriers according to one of the claims 1-9 and claim 11, **characterized in that** the basic strip conductor arrangement is modified to produce the strip conductor arrangement (3) ready for installation by some or all strip conductors being trimmed and/or shortened.

13. Method for producing a component carrier of a system of component carriers according to one of the claims 1-12, **characterized in that** the strip conductor arrangement (3) is embedded in the carrier element (2) and is produced together with said carrier element.

14. Method for producing a component carrier of a system of component carriers according to one of the claims 1-13, **characterized in that** the two connections (5, 6) are produced to form a single component together with the carrier element (2).

## Revendications

1. Système de support pour logement de composants électriques/électroniques (1) en particulier dans une serrure de portière de véhicule automobile avec au moins un élément de support commun (2) avec au moins un élément de raccordement électrique (5, 6) et avec une structure de bande conductrice (3) pour contact électrique des composants (1), **caractérisé en ce que** deux ou plusieurs d'éléments de raccordement électrique (5, 6) sont prévus à l'élément de support qui sont activés au choix ou ensemble par le fait qu'une structure de bande conductrice (3, 3', 3") prête au montage correspondant au choix d'activation est sélectionnée et utilisée.

2. Système de support pour logement de composants électriques/électroniques (1) en particulier dans une serrure de portière de véhicule automobile avec au moins un élément de support commun (2) avec au moins
un élément de raccordement électrique (5, 6) et avec une structure de bande conductrice (3) en surface pour contact électrique des composants (1), **caractérisé en ce que** deux ou plusieurs éléments de raccordement électrique (5, 6) sont prévus à l'élément de support qui sont activés au choix ou ensemble par le fait qu'une structure de bande conductrice de base modifiées en fonction du choix d'activation est utilisée comme structure de bande conductrice (3) prête au montage.

3. Système de support selon l'une des revendications 1 à 2 **caractérisé en ce que** les deux éléments de raccordement électrique (5, 6) sont placés en extension longitudinale et transversalement par rapport à l'extension longitudinale de l'élément de support (2).

4. Système de support selon l'une des revendications 1 à 3 **caractérisé en ce que** les éléments de raccordement électrique (5, 6) forment une seule pièce avec l'élément de support (2)

5. Système de support selon l'une des revendications 1 à 4 **caractérisé en ce que** la structure de bande conductrice (3) est logée dans l'élément de support (2) et est fabriqué avec ce dernier.

6. Système de support selon l'une des revendications 1 à 5 **caractérisé en ce que** la structure de bande conductrice (3) plonge avec au moins un élément de contact (4) dans l'élément de raccordement électrique (5, 6) vers son point de contact.

7. Système de support selon l'une des revendications 1 à 6 **caractérisé en ce que** l'élément de support (2) est saisi entre des composants de la serrure de portière de véhicule automobile, par exemple le couvercle (11) et le boîtier (9).

8. Système de support selon l'une des revendications 1 à 7 **caractérisé en ce que** la structure de bande conductrice (3) est exécutée de préférence en surface et comme grillage estampé.

9. Système de support selon l'une des revendications 1 à 8 **caractérisé en ce que** des joints (12, 13) sont prévus entre l'élément de support (2) et les composants (9, 10) de la serrure de portière de véhicule automobile et/ou dans la zone des éléments de raccordement électrique (5,6).

10. Procédure de fabrication d'un support d'un système de supports de composants selon l'une des revendications 1-9 pour logement de composants électriques/électroniques (1) en particulier dans une serrure de portière de véhicule automobile avec au moins un élément de support commun (2), de plus avec au moins un élément de raccordement électrique (5, 6) et avec une structure de bande conductrice (3) pour contact électrique des composants (1), **caractérisée en ce que** deux ou plusieurs éléments de raccordement électrique (5, 6) sont prévus à l'élément de support qui sont activés au choix ou ensemble par le fait qu'une structure de bande conductrice (3, 3', 3") prête au montage correspondant au choix d'activation est sélectionnée et utilisée.

11. Procédure de fabrication d'un support d'un système de supports de composants selon l'une des revendications 1-9 pour logement de composants électriques/électroniques (1) en particulier dans une serrure de portière de véhicule automobile avec au moins un élément de support commun (2) de plus avec au moins
un élément de raccordement électrique (5, 6) et avec une structure de bande conductrice (3) pour contact électrique des composants (1), **caractérisée en ce que** deux ou plusieurs d'éléments de raccordement électrique (5, 6) sont prévus à l'élément de support qui sont activés au choix ou ensemble par le fait qu'une structure de bande conductrice de base est modifiée et utilisée en fonction du choix d'activation conformément à la structure de bande conductrice (3) prête au montage.

12. Procédure de fabrication d'un support d'un système de supports de composants selon l'une des revendications 1-9 et la revendication 11 **caractérisée en ce que** la structure de bande conductrice de base est transformée par pliage et/ou raccourcissement de différentes ou de l'ensemble des bandes conductrices en structure de bande conductrice (3).

13. Procédure de fabrication d'un support d'un système de supports de composants selon l'une des revendications 1-12 **caractérisée en ce que** la structure de bande conductrice (3) est logée dans l'élément de support (2) et fabriqué avec ce dernier.

14. Procédure de fabrication d'un support d'un système de supports de composants selon l'une des revendications 1-13 caractérisée en ce les deux raccordements (5, 6) sont fabriqués en une seule pièce avec l'élément de support (2).
